# EUROPEAN PATENT APPLICATION

(11) **EP 2 390 920 A2**
(43) Date of publication of application: **30.11.2011**
(21) Application number: 11166895.0
(22) Date of filing: 20.05.2011
(51) Int. Cl.: H01L 27/142

(54) **Monolithically integrated solar modules and methods of manufacture**

(30) Priority: 28.05.2010 US 790689
(71) Applicant: General Electric Company, Schenectady, NY 12345 (US)
(72) Inventor: Korevaar, Bastiaan Arie, Niskayuna, NY 12309 (US)
(74) Representative: Bedford, Grant Richard

(57) **Abstract**

A monolithically integrated photovoltaic (PV) module (200) is provided and includes a first electrically conductive layer (12) and an insulating layer (24). The first electrically conductive layer is disposed below the insulating layer. The PV module further includes a back contact metal layer (28), a p-type semiconductor layer (14), a substantially intrinsic semiconductor layer (16) with a median grain size of at least about five µm and comprising cadmium and tellurium, and an n-type semiconductor layer (18). The substantially intrinsic layer is disposed between the p-type and the n-type semiconductor layers forming an active semiconductor stack (30). The back contact metal layer is disposed between the insulating layer and the active semiconductor stack. The PV module further includes a second electrically conductive layer (22) disposed above the active semiconductor stack (30), at least one first trench (11) extending through the back contact metal layer (28), at least one second trench (13) extending through the active semiconductor stack, and at least one third trench (15) extending through the second electrically conductive layer (22).

## Description

The invention relates generally to photovoltaic cells and, more particularly, to monolithically integrated Cadmium Telluride (CdTe) modules.

PV (or solar) cells are used for converting solar energy into electrical energy. Typically, in its basic form, a PV cell includes a semiconductor junction made of two or three layers that are disposed on a substrate layer, and two contacts (electrically conductive layers) for passing electrical energy in the form of electrical current to an external circuit. Moreover, additional layers are often employed to enhance the conversion efficiency of the PV device.

There are a variety of candidate material systems for PV cells, each of which has certain advantages and disadvantages. CdTe is a prominent polycrystalline thin-film material, with a nearly ideal bandgap of about 1.45-1.5 electron volts. CdTe also has a very high absorptivity, and films of CdTe can be manufactured using low-cost techniques.

In order to form solar modules, PV cells must be electrically interconnected. The conventional interconnection approach involves connecting discrete cells together via shingling or metallic ribbons. In the conventional approach, interconnected cells do not maintain a common substrate.

Another interconnection technique is monolithic integration, in which PV cells are electrically interconnected as part of the cell fabrication process. Monolithic integration typically is implemented for thin film PV modules, where PV layers are deposited over large area substrates. Thin film PV modules are implemented by dividing the module into individual cells that are series connected to provide a high voltage output. Scribe and pattern steps are often used to divide the large area into electrically interconnected cells while maintaining a common substrate. This approach is typically applied to solar cells that are deposited on glass.

Several approaches exist for implementing monolithic integration, and each approach has various advantages and disadvantages related to the fabrication sequence, required tools, and material interactions, among other factors.

One of the key challenges in thin film PV fabrication relates to the need to isolate the top contacts of neighboring cells, i.e., scribe through the top conducting outer layer without damaging the underlying layers. Three scribes are typically necessary to form a monolithic interconnect. The spacing between scribes should be wide enough to overcome the possibility of unwanted electrical connections. However, the total area occupied by the scribes, plus any space between scribes, should ideally be as small as possible to maximize the absorbing area of the PV cell. Mechanical scribing is often not practical for flexible substrates, and laser scribing can be challenging, if the underlying layers are more highly absorbing than the overlying layer.

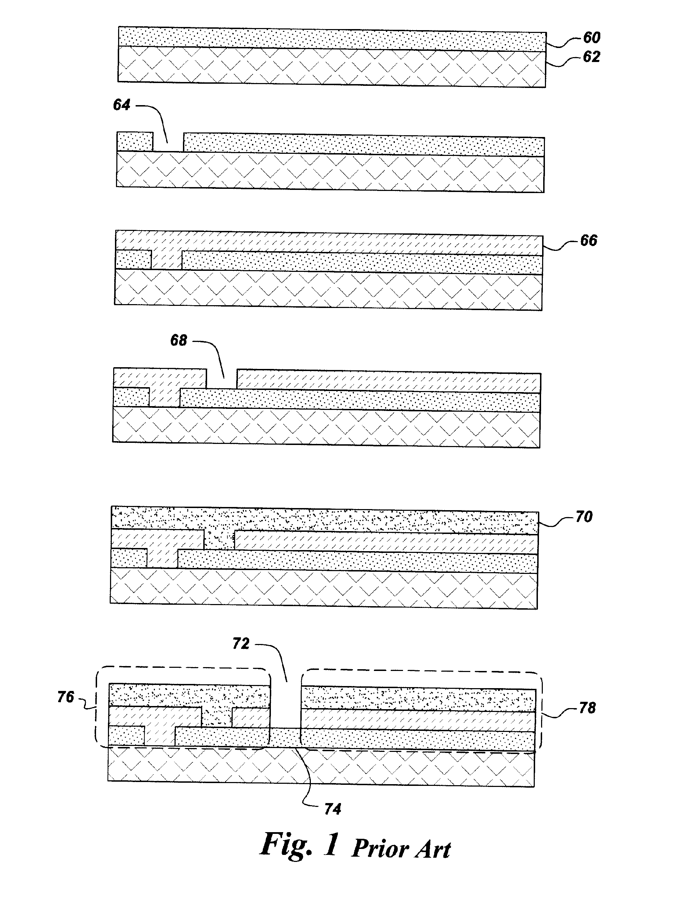

FIG. 1 illustrates an example, conventional monolithic PV cell interconnect process for a copper indium gallium diselenide (Cu(In, Ga)Se₂ or CIGS) cell. As shown, for example, in FIG. 1, the process begins by depositing a first conducting layer 60 on a substrate 62. For the illustrated process, the first conducting layer 60 is scribed using a linear cut 64 across the module. A semiconductor layer 66, such as a CIGS, layer is then deposited as depicted in FIG. 1. A second scribe 68 parallel to the first scribe 64 isolates the CIGS layer 66 into individual PV cells. A second conducting layer 70, for example a transparent conductive oxide (TCO) layer, is then deposited as also depicted in FIG. 1. The monolithic integration process is completed with a third scribe 72, which leaves the series connection 74, in which the TCO from the second conducting layer 70 connects the top of one PV cell 76 to the bottom of the next PV cell 78. The resulting monolithically integrated CIGS cells 76, 78 have what is termed a "substrate geometry." Namely, the cells 76, 78 are disposed on an insulating substrate 62 (which is typically glass) and include a transparent upper contact formed from TCO layer 70.

Monolithic interconnection is typically limited in application to PV module fabrication on glass substrates due to the inherent difficulties in aligning the three scribes for cells grown on flexible substrates. However, in order to manufacture light weight and robust CdTe solar modules, it would be desirable to use flexible substrates, such as metal or polymer webs.

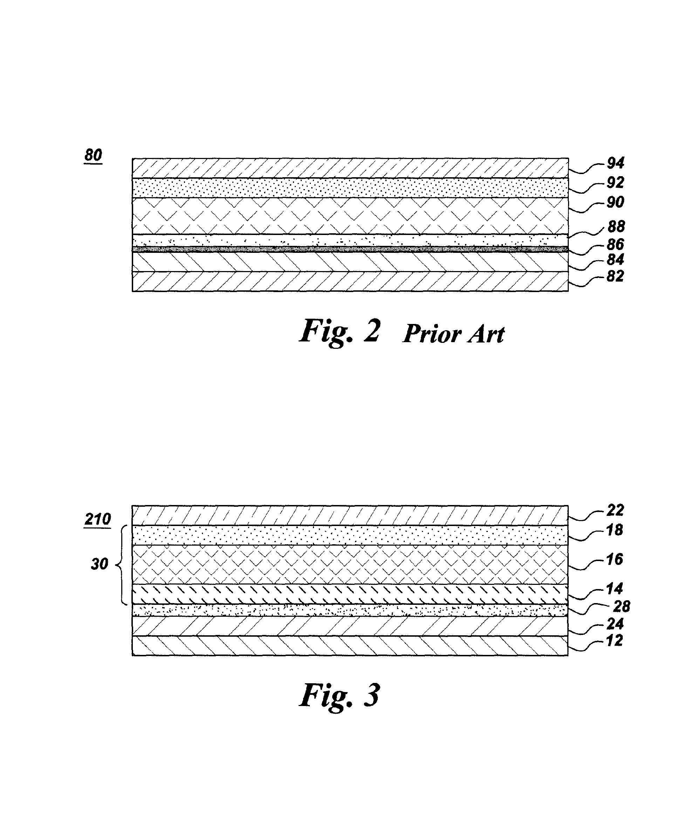

Conventional CdTe PV cells are deposited in a "superstrate" geometry, as illustrated in FIG. 2. As shown in FIG. 2, the CdTe solar cell 80 is formed on a glass substrate 82. A transparent conductive layer 84, typically a TCO layer 84 is deposited on the glass substrate 82. Next, an optional high resistance transparent conductive oxide (HRT) layer 86 may be deposited on the TCO layer 84, and typically a CdS layer 88 is deposited on the HRT layer 86. A CdTe layer 90 is deposited on the CdS layer 88, and a back contact 92 is formed. In addition, an upper glass substrate 94 may be included to provide an inexpensive, environmental barrier.

However, conventional CdTe cells manufactured in superstrate geometries, can have certain drawbacks. For example, it may not be possible to optimize the window layer because of the subsequent deposition of the absorber layer at high temperatures. Further, conventional CdTe cells deposited in superstrate geometries typically are formed on a glass substrate 82, which can add to the overall weight and detract from the robustness of the resulting PV module.

It would therefore be desirable to provide a method for manufacturing CdTe PV cells in a substrate geometry, such that flexible substrates, such as metal or polymer webs, can be employed. It would further be desirable to provide a method for monolithically integrating CdTe PV cells deposited in a substrate geometry, in order to reduce processing time and cost.

One aspect of the present invention resides in a monolithically integrated photovoltaic (PV) module that includes a first electrically conductive layer and an insulating layer. The first electrically conductive layer is disposed below the insulating layer. The monolithically integrated PV module further includes a back contact metal layer, a p-type semiconductor layer, and a substantially intrinsic semiconductor layer with a median grain size of at least about five (5) µm and comprising cadmium and tellurium. The monolithically integrated PV module further includes an n-type semiconductor layer. The substantially intrinsic semiconductor layer is disposed between the p-type semiconductor layer and the n-type semiconductor layer forming an active semiconductor stack. The back contact metal layer is disposed between the insulating layer and the active semiconductor stack. The monolithically integrated PV module further includes a second electrically conductive layer disposed above the active semiconductor stack and at least one first trench extending through the back contact metal layer. Each of the first trenches separates the back contact metal layer for a respective PV cell from the back contact metal layer of a respective neighboring PV cell. At least one second trench extends through the p-type semiconductor, substantially intrinsic semiconductor, and n-type semiconductor layers. Each of the second trenches separates the p-type semiconductor, substantially intrinsic semiconductor, and n-type semiconductor layers for a respective PV cell from the p-type semiconductor, substantially intrinsic semiconductor, and n-type semiconductor layers of a respective neighboring PV cell. At least one third trench extends through the second electrically conductive layer. Each of the third trenches separates the second electrically conductive layer for a respective PV cell from the second electrically conductive layer of a respective neighboring PV cell.

Another aspect of the present invention resides in a method for monolithically integrating photovoltaic (PV) cells. The monolithic integration method includes providing a first electrically conductive layer, depositing an insulating layer above the first electrically conductive layer, depositing a back contact metal layer above the insulating layer, and forming at least one first trench extending through the back contact metal layer. The monolithic integration method further includes depositing an active semiconductor stack above the back contact metal layer. The active semiconductor stack comprises a substantially intrinsic semiconductor layer with a median grain size of at least about five (5) µm disposed between a p-type semiconductor layer and an n-type semiconductor layer. The monolithic integration method further includes forming at least one second trench extending through the p-type, substantially intrinsic and n-type semiconductor layers, depositing a second electrically conductive layer at least partially above the active semiconductor stack, and forming at least one third trench extending through the second electrically conductive layer.

Various features, aspects, and advantages of the present invention will become better understood when the following detailed description is read with reference to the accompanying drawings in which like characters represent like parts throughout the drawings, wherein:
FIG. 1 illustrates an example, conventional monolithic PV cell interconnect process for CIGS;
FIG. 2. illustrates a conventional CdTe PV cell manufactured in a "superstrate" configuration;
FIG. 3 is a schematic cross-sectional diagram of an example CdTe n-i-p structure manufactured in a "substrate" configuration;
FIG 4 illustrates the first three steps for an example, monolithic integration process for manufacturing CdTe PV cells in a "substrate" configuration and with the n-i-p structure shown in FIG. 3, in accordance with embodiments of the present invention;
FIG. 5 illustrates the next three steps for the example process shown in FIG. 4;
FIG. 6 is a schematic cross-sectional diagram of another example CdTe n-i-p structure, with an HRT layer and manufactured in a "substrate" configuration;
FIG. 7 is a schematic cross-sectional diagram of an example monolithically integrated CdTe module, deposited in a "substrate" configuration and with the n-i-p structure and the HRT layer of FIG. 6;
FIG. 8 is a schematic cross-sectional diagram of an example CdTe p-i-n structure manufactured in a "substrate" configuration; and
FIG. 9 is a schematic cross-sectional diagram of an example monolithically integrated PV module manufactured in a "substrate" geometry for PV cells with a p-i-n structure.

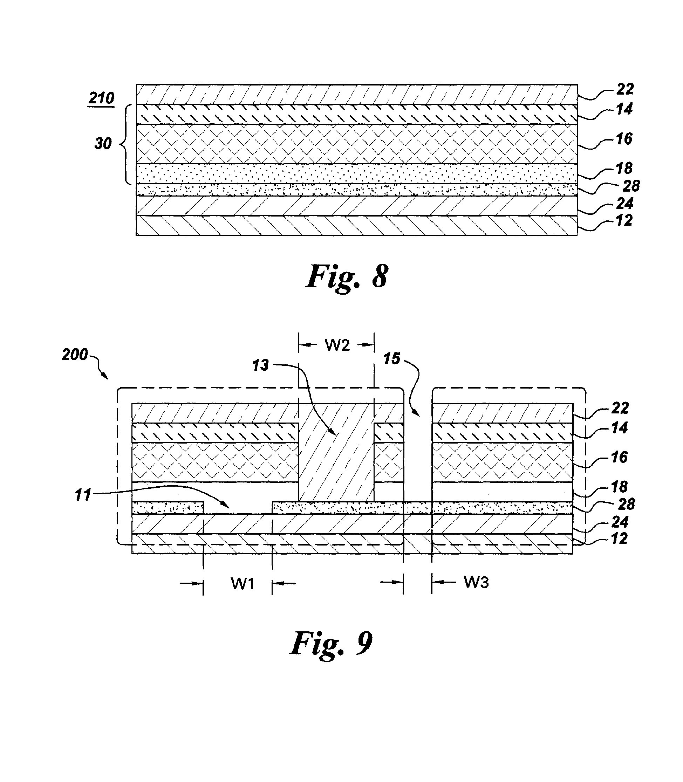

In one aspect a method to monolithically integrate CdTe PV cells manufactured in a "substrate" configuration is provided. The monolithically interconnected module 200 may be formulated from a single device 210, such as the CdTe n-i-p structure depicted in FIG. 3 or the CdTe p-i-n structure depicted in FIG. 8. Each of the structures of FIGS. 3 and 8 is in a "substrate" (as opposed to the conventional "superstrate") configuration for CdTe cells. The configurations shown in FIGS. 3 and 8 include a first electrically conductive layer 12, a p-type semiconductor layer 14, a substantially intrinsic (i-type) semiconductor layer 16, an n-type semiconductor layer 18 and a second electrically conductive layer 22. As indicated in FIGS. 3 and 8, the p-type semiconductor layer 14, substantially intrinsic (i-type) semiconductor layer 16, and n-type semiconductor layer 18 form an active semiconductor stack 30. For the example arrangement shown in FIG. 3, the first electrically conductive layer 12 is disposed below the p-type semiconductor layer 14, and the n-type semiconductor layer 18 is disposed below the second electrically conductive layer 22, such that light is incident through the n-type semiconductor layer 18.

For the configuration shown in FIG. 3, the substantially intrinsic CdTe layer 16 is disposed between the p-type semiconductor layer 14 and the n-type semiconductor layer 18, thereby forming an n-i-p structure 30. As known in the art, carrier pairs generated in the substantially intrinsic CdTe layer are separated by an internal field generated by the respective doped layers, so as to create the photovoltaic current. In this manner, the n-i-p structure, when exposed to appropriate illumination, generates a photovoltaic current, which is collected by the electrically conductive layers 12, 22, which are in electrical communication with appropriate layers of the device.

Similarly, for the example arrangement shown in FIG. 8, the first electrically conductive layer 12 is disposed below the n-type semiconductor layer 18, and the p-type semiconductor layer 14 is disposed below the second electrically conductive layer 22, such that light is incident through the p-type semiconductor layer 14, thereby forming an p-i-n structure (which is also indicated by reference numeral 30).

The substantially intrinsic semiconductor layer 16 comprises cadmium and tellurium, and more particularly, comprises a material selected from the group consisting of cadmium telluride (CdTe), cadmium zinc telluride, cadmium sulfur telluride, cadmium manganese telluride, cadmium magnesium telluride and combinations thereof. As used here, the phrase "substantially intrinsic" should be understood to denote a material with a carrier concentration of less than about 10¹³ per cubic centimeter (cc). As will be recognized by those skilled in the art, carrier concentrations in this range can be achieved for both actively doped material and material formed without the active introduction of dopants. Non-limiting examples of n-type dopants for CdTe include aluminum, indium, chlorine, bromine and iodine. For CdTe, suitable p-type dopants include, without limitation, copper, nitrogen, phosphorus, antimony, arsenic and sodium.

For certain configurations, the substantially intrinsic semiconductor layer 16 comprises cadmium telluride (CdTe). However, the intrinsic layer 16 may, in certain embodiments, comprise other elements from the Group II and Group VI or Group III and Group V that will not result in large bandgap shifts (for example, bandgap shifts that are ≤ 0.1 eV), such as zinc, sulfur, manganese and magnesium. For specific configurations, the atomic percent of cadmium in the CdTe is in the range from about 48-52 atomic percent, and the atomic percent of tellurium in the CdTe is in the range from about 45-55 atomic percent. The CdTe employed may be Te-rich, for example the atomic percent of tellurium may be in the range from about 52-55 atomic percent. For specific configurations, the atomic percent of zinc, sulfur, manganese, or magnesium in the CdTe is less than about 10 atomic percent, and more particularly, about 8 atomic percent, and still more particularly, about 6 atomic percent, with the bandgap staying in the 1.4-1.6 eV range. It has been postulated that by adding a small atomic percent of zinc, the defect density of the resulting intrinsic cadmium zinc telluride is reduced relative to CdTe. However, it is possible that instead the defect state may shift to a different energy level within the band, resulting in a different self-compensating level, e.g., may result in more donor/acceptor type states, or a less deep defect, that may improve the lifetime. However, ten atomic percent of zinc will bring the bandgap up to about 1.55 eV. Similarly, the addition of sulfur will vary the bandgap of the resulting intrinsic cadmium sulfur telluride between about 1.4 and 1.5 eV, for small atomic S percentages. See, for example, D.W. Lane, "A review of the optical band gap of thin film CdSxTe1-x," Solar Energy Materials & Solar Cells 90 (2006) 1169-1175, and Jihua Yang et al., "Alloy composition and electronic structure of Cd1ÀxZnxTe by surface photovoltage spectroscopy," Journal of Applied Physics, Vol. 91, No. 2, p. 703-707.

Traditionally, the performance of a CdTe-based device has been explained by assigning bulk properties to the CdTe. However, there are increasing indications that the device performance is primarily controlled by the properties of the grain boundaries. According to a particular embodiment, the substantially intrinsic semiconductor layer 16 comprises a number of grains separated by grain boundaries and has a median grain size of at least about five (5) µm. The grains are either slightly p-type or slightly n-type. For particular embodiments, at least ninety percent (90%) of the grains (in cross-sectional view) within the substantially intrinsic semiconductor layer 16 are characterized by a grain size of at least about five (5) µm. According to more particular examples, at least 90% of the grains within the substantially intrinsic semiconductor layer 16 are characterized by a grain size of at least about ten (10) µm, and more particularly, at least about twenty (20) µm. In addition, for certain configurations, the substantially intrinsic semiconductor layer 16 has a thickness of less than two (2) µm. For more particular configurations, the ratio of the median grain size for the substantially intrinsic semiconductor layer 16 to the thickness of the substantially intrinsic semiconductor layer 16 is greater than two, and more particularly, greater than five, and still more particularly, greater than ten. In one non-limiting example, the ratio of the median grain size to the thickness of the substantially intrinsic semiconductor layer is about 2.5. Beneficially, by controlling this ratio, the grain-boundaries are relatively far away, such that the charge carriers are more likely to encounter one of the front and back contacts than a grain boundary, especially in a drift device.

To avoid formation of a potential barrier at the p-i interface, the material for the p-type semiconductor layer 14 should be selected to avoid a bandgap discontinuity between the p-type and intrinsic layers. For example, ΔE_{g}< 0.05 eV at the interface between the intrinsic and p-type materials. Non-limiting example materials for the p-type semiconductor layer 14 include zinc telluride (ZnTe), CdTe, magnesium telluride (MgTe), manganese telluride (MnTe), beryllium telluride (BeTe) mercury telluride (HgTe), copper telluride (CuₓTe), and combinations thereof. These materials should also be understood to include the alloys thereof. For example, CdTe can be alloyed with zinc, magnesium, manganese, and/or sulfur to form cadmium zinc telluride, cadmium copper telluride, cadmium manganese telluride, cadmium magnesium telluride and combinations thereof. These materials may be actively doped to be p-type. Suitable dopants vary based on the semiconductor material. For CdTe, suitable p-type dopants include, without limitation, copper, gold, nitrogen, phosphorus, antimony, arsenic, silver, bismuth, and sodium. According to a particular embodiment, the p-type semiconductor layer 14 comprises doped ZnTe (for example, ZnTe:Cu or ZnTe:N) and has a thickness in a range of about 50-100 nm.

For certain configurations, the p-type semiconductor layer 14 and the substantially intrinsic semiconductor layer 16 form a compositionally graded layer transitioning from a p-type semiconductor material to substantially intrinsic CdTe. For example, this transition may occur over a distance of about 100 nm.

For the configuration shown in FIG. 3, where the p-type semiconductor layer 14 is at the back of the device, there is no real limitation on the p-type semiconductor layer thickness. Instead, the p-type semiconductor layer may be just thick enough to be 'present' and thin enough to not contribute to the resistance. However, for the configurations shown in FIG. 8, where light enters through the p-type semiconductor layer 14, the thickness of the p-type semiconductor layer 14 needs to be minimized, although it must be thick enough to be electrically present to generate the electric field in the intrinsic layer. For the configuration shown in FIG. 8, the ratio of the thickness of the intrinsic layer to the thickness of the p-type semiconductor layer ratio is greater than 5:1 for certain examples, and for particular examples is greater than about 20:1, and for still more particular example is about 100:1. For example, the intrinsic CdTe layer may be 2 µm thick and the p-type window layer may be 100 nm in thickness. If, however, the p-type window layer is more highly doped, the p-type layer may be as thin as 20 nm, making this ratio 100:1.

For the configuration shown in FIG. 3, the n-type semiconductor layer 18 functions as a window layer. Namely, the n-type semiconductor layer 18 is the junction-forming layer for the PV device 10, for the configuration shown in FIG. 3. The addition of the n-type semiconductor layer 18 induces an electric field that produces the photovoltaic effect. Non-limiting example materials for the n-type semiconductor layer 18 include cadmium sulfide (CdS), indium (III) sulfide (In₂S₃), indium selenide (In₂Se₃), zinc sulfide (ZnS), zinc telluride (ZnTe), zinc selenide (ZnSe), cadmium selenide (CdSe), oxygenated cadmium sulfide (CdS:O), copper oxide (Cu₂O), and Zn(O,H) and combinations thereof. According to a particular embodiment, the n-type semiconductor layer 18 comprises CdS and has a thickness in a range of about 50-200 nm, and more particularly between 50 and 100 nm. The atomic percent of cadmium in the cadmium sulfide, for certain configurations, is in a range of about 45-55 atomic percent, and more particularly, in a range of about 48-52 atomic percent.

For more specific configurations, the n-type semiconductor layer 18 comprises CdS, thereby providing a heterojunction interface between the substantially intrinsic semiconductor layer 16 and the CdS layer 18. For one non-limiting example configuration for the arrangement of FIG. 3, the n-type semiconductor layer 18 comprises an amorphous silicon based window layer (a-Si:H). Similarly, for one non-limiting example configuration of the p-i-n arrangement of FIG. 8, the n-type semiconductor layer 18 comprises CdTe and the p-type semiconductor layer 14 comprises an amorphous silicon based window layer (a-Si:H).

For particular configurations, the first electrically conductive layer 12 comprises a metal substrate, and non-limiting materials for the metal substrate 12 include nickel, nickel alloys, copper and copper alloys, stainless steel and stainless steel alloys, and molybdenum and molybdenum alloys. In order to perform monolithic integration on the semiconductor stack shown in FIG. 3, the first electrically conductive layer 12 must be separated from the semiconductor layers 14, 16, 18 by one or more insulating layers. For the configuration shown in FIG. 3, the PV cell 210 further includes an insulating layer 24 disposed between the first electrically conductive layer 12 and the p-type semiconductor layer 14. Similarly, for the configuration shown in FIG. 8, the PV cell 210 further includes an insulating layer 24 disposed between the first electrically conductive layer 12 and the n-type semiconductor layer 18.

For particular embodiments, the insulating layer 24 comprises silicon, titanium, tin, lead, or germanium. Non-limiting example materials for the insulating layer 24 include single crystal or polycrystalline insulators formed using materials, such as silicon dioxide (SiO₂), titanium dioxide (TiO₂ and silicon oxycarbide (SiOC). According to more particular embodiments, the insulating layer has the formula SiOₓC_{y}H_{z}, and x, y and z each have values in a range of about 0.001-2 respectively, more particularly about 0.01 to about 0.9, and still more specifically about 0.1 to about 0.5. In one non-limiting example, x is about 1.8, y is about 0.4 and z is about 0.07. When formed from these materials, the insulating layer 24 retains its insulating properties at a temperature greater than or equal to about 300°C, more particularly at temperatures greater than or equal to about 400°C, and still more particularly, at temperatures greater than or equal to about 500°C.

In one embodiment, the insulating layer 24 is substantially amorphous. The insulating layer 24 can have an amorphous content of about 10 to about 90 weight percent (wt %), based upon the total weight of the insulating layer. For particular arrangements, the insulating layer 24 is completely amorphous.

For particular configurations, the insulating layer 24 has a thickness in a range of about 1-100 µm, more particularly about 1-50 µm, and still more particularly about 2 - 20 µm. In one non-limiting example, the insulating layer 24 has a thickness of about 5 µm.

Beneficially, the presence of the insulating layer 24 electrically isolates cells to facilitate monolithic integration of the PV cells 10 into a solar module (such as 200). In addition, the insulating layer 24 may act as a diffusion barrier to prevent diffusion of the metal (for example, nickel) from the contact 12 into the p-type material 14 for the n-i-p configuration of FIG. 3.

The configuration shown in FIG. 3 further includes a metal layer 28 disposed between the insulating layer 24 and the p-type semiconductor layer 14. Similarly, the configuration shown in FIG. 8 further includes a metal layer 28 disposed between the insulating layer 24 and the n-type semiconductor layer 18. The metal layer 28 may comprise molybdenum, aluminum, chromium, gold, tungsten, tantalum, titanium, nickel, alloys thereof, or a combination/stack thereof. In one non-limiting example, the metal layer 28 comprises molybdenum or an alloy thereof, possibly in combination with aluminum, where the aluminum is farthest away from the semi-conductor layer. For the n-i-p configuration of FIG. 3, the metal layer 28 is used to make an ohmic contact with the p-type layer 14. Similarly, for the p-i-n configuration of FIG. 8, the metal layer 28 is used to make an ohmic contact with the n-type layer 18.

For certain arrangements, the second electrically conductive layer 22 comprises a transparent conductive oxide (TCO). Non-limiting examples of transparent conductive oxides include indium tin oxide (ITO), fluorine-doped tin oxide (SnO:F) or FTO, indium-doped cadmium-oxide, cadmium stannate (Cd₂SnO₄) or CTO, and doped zinc oxide (ZnO), such as aluminum-doped zinc-oxide (ZnO:AI) or AZO, indium-zinc oxide (IZO), and zinc tin oxide (ZnSnOₓ), and combinations thereof. Depending on the specific TCO employed (and on its sheet resistance), the thickness of the TCO layer 22 may be in the range of about 50-500 nm and, more particularly, 100-200 nm.

For particular configurations, the first electrically conductive layer 12 comprises a textured substrate. Non-limiting materials for the textured substrate 12 include nickel, nickel alloys, copper and copper alloys, and molybdenum and molybdenum alloys. As discussed in US 2007/0044832, Fritzemeier, "Photovoltaic Template," the textured substrate may be formed by deforming a substrate, and metal deformation techniques known to those skilled in the art can be used to produce sharp textures. Fritzemeier teaches that face centered cubic (fcc) metals, body centered cubic (bcc) metals and some alloys based on fcc metals can be used as the deformation substrate material, as they can be biaxially textured using well known rolling deformation and annealing processes. In particular, a "cube texture" can be achieved in fcc metals and alloys, using controlled rolling and annealing processes, such that the resulting deformation textured metal tapes possess textures that approach single crystal quality. An intermediate epitaxial film may be deposited on the textured substrate prior to deposition of the anticipated semiconductor film. Preferably, the texture of the substrate 12 is reproduced in the texture of the intermediate epitaxial film. Beneficially, the textured substrate 12 can be used as a template for growth of a substantially intrinsic semiconductor layer 16 with a median grain size of at least about five (5) µm. By using large grains, i.e., grains that are much larger than the thickness of the film, the electron-hole recombination at the defects associated with the grain-boundaries is reduced. If the quality of the grains is sufficiently high, carrier lifetimes in excess of one nanosecond can be achieved. Beneficially, by achieving longer carrier lifetimes, higher efficiencies can be achieved.

In one non-limiting example, the first electrically conductive layer 12 comprises a textured substrate (for example, a stamped nickel substrate) with a thin metal film (not shown) deposited on the stamped substrate to act as a barrier to prevent diffusion of the nickel into the subsequently deposited semiconductor layers and/or to enhance ohmic contact to the p-type semiconductor layer 14 for the n-i-p configuration of FIG. 3 (and to the n-type semiconductor layer 18 for the p-i-n configuration of FIG. 8). The metal used to form the thin metal film should be selected to optimize the efficiency of the PV device 10 and preferably remain stable in the environment of CdTe. In one non-limiting example, a molybdenum (or alloy thereof) film is used. In other examples, a tantalum or tungsten (or alloys thereof) film is employed.

In addition, interface defects must also be reduced, in order to increase carrier lifetimes. To reduce interface defects in PV cell 10, the crystallographic alignment of the n-type semiconductor layer 18 with the substantially intrinsic semiconductor layer 16 and the crystallographic alignment of the p-type semiconductor layer 14 with the substantially intrinsic semiconductor layer 16 need to be controlled. For example, the n-type semiconductor layer 18 and the substantially intrinsic semiconductor layer 16 should be substantially lattice matched (that is, their crystal structure and lattice constant should be sufficiently close) to permit the oriented growth of the n-type semiconductor layer 18 on the substantially intrinsic semiconductor layer 16, for the n-i-p configuration shown in FIG. 3. However, other passivation techniques may also be applied. More critically, the p-type semiconductor layer 14 and the substantially intrinsic semiconductor layer 16 should be substantially lattice matched to permit the oriented growth of the substantially intrinsic semiconductor layer 16 on the p-type semiconductor layer 14, for the n-i-p configuration shown in FIG. 3. In particular, the oriented growth of the intrinsic layer is more critical, and thus lattice matching at the interface between the p-type layer 14 and the intrinsic layer 16 is particularly important, for the n-i-p configuration shown in FIG. 3. Similarly, for the p-i-n configuration of FIG. 8, the oriented growth of the intrinsic layer is critical, and thus lattice matching at the interface between the n-type layer 18 and the intrinsic layer 16 is particularly important.

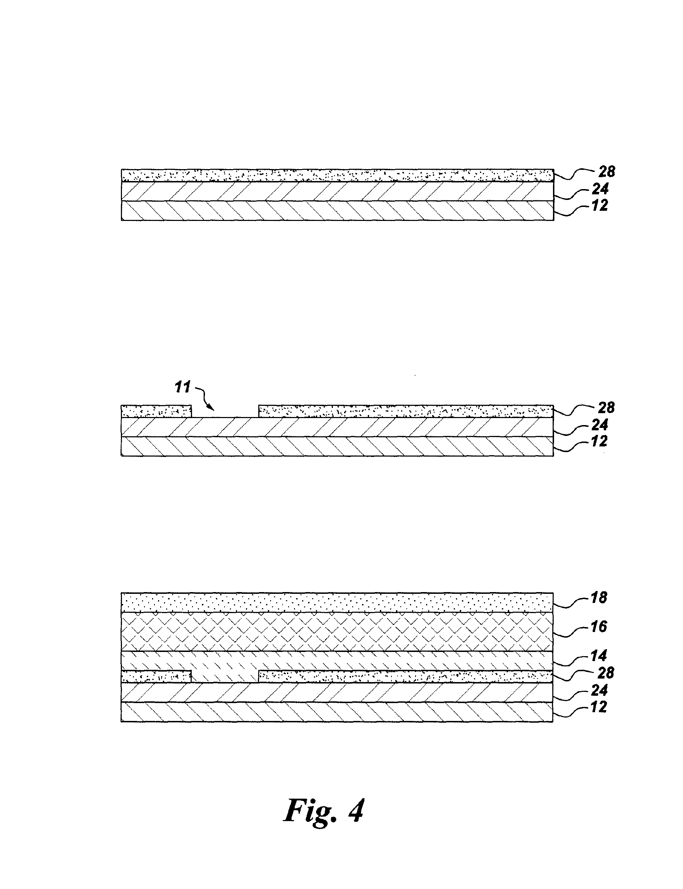

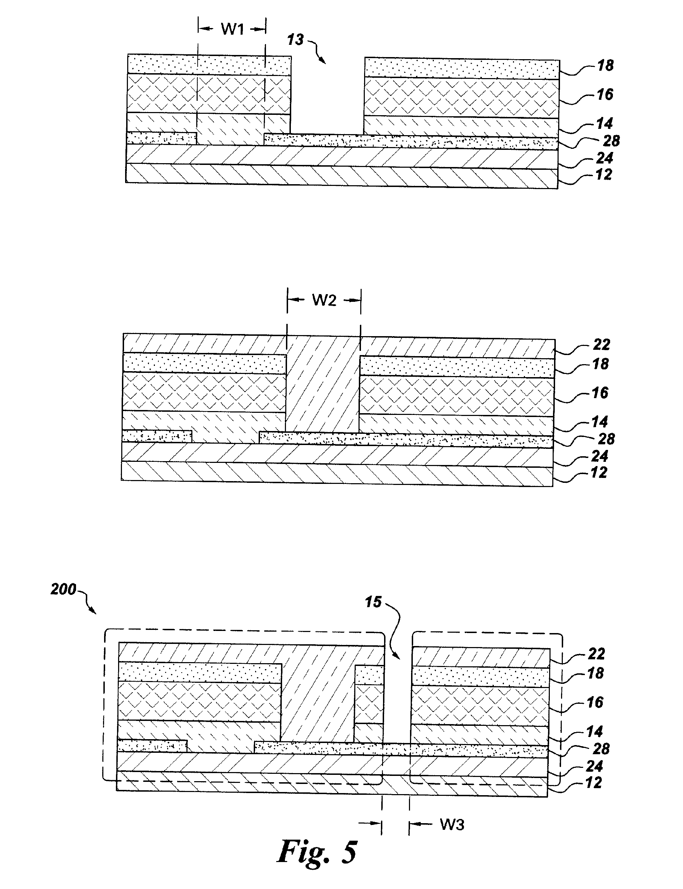

A monolithically integrated photovoltaic (PV) module 200 embodiment of the invention is described with reference to FIGS. 4-7 and 9, and a monolithically integrated PV module 200 manufactured in a "substrate" geometry for PV cells with a n-i-p structure is shown in the lower most portion of FIG. 5. Similarly, a monolithically integrated PV module 200 manufactured in a "substrate" geometry for PV cells with a p-i-n structure is shown in FIG. 9. Although FIGS. 4 and 5 illustrate the monolithic integration process for CdTe PV cells with an n-i-p structure, a similar process may be employed to monolithically integrate CdTe PV cells with a p-i-n structure, with the order of the deposition of the n-type and p-type layers 18, 14 being reversed.

As shown, for example in FIGS. 5 and 9, the monolithically integrated PV module 200 includes a first electrically conductive layer 12 and an insulating layer 24. For the arrangement shown in FIG. 4, the first electrically conductive layer is disposed below the insulating layer. The first electrically conductive layer 12 and the insulating layer 24 are discussed above with reference to FIGS. 3 and 8 in detail. According to particular embodiments, the first electrically conductive layer 12 comprises a textured substrate 12 and, more particularly, the insulating layer 24 is conformal with the roughness of the textured substrate 12.

The monolithically integrated PV module 200 further includes a back contact metal layer 28, a p-type semiconductor layer 14, a substantially intrinsic semiconductor layer 16, and an n-type semiconductor layer 18. For the p-i-n arrangement shown in FIG. 9, the back contact metal layer 28 is disposed between the insulating layer 24 and the n-type semiconductor layer 18. For the n-i-p arrangement shown in FIG. 5, the back contact metal layer 28 is disposed between the insulating layer 24 and the p-type semiconductor layer 14. According to particular embodiment, the p-type semiconductor layer 14 comprises doped ZnTe (for example, ZnTe:Cu or ZnTe:N) and has a thickness in a range of about 50-100 nm. The back contact metal layer 28 and the p-type semiconductor layer 14 are discussed above with reference to FIG. 3 in detail.

The substantially intrinsic semiconductor layer 16 has a median grain size of at least about five (5) µm. The substantially intrinsic semiconductor layer 16 is discussed in detail above with reference to FIGS. 3 and 8 and comprises cadmium and tellurium, and more particularly, comprises a material selected from the group consisting of cadmium telluride (CdTe), cadmium zinc telluride, cadmium sulfur telluride, cadmium manganese telluride, cadmium magnesium telluride and combinations thereof. For example configurations, the substantially intrinsic semiconductor layer 16 has a thickness of less than two (2) µm. For specific arrangements, the ratio of the median grain size for the substantially intrinsic semiconductor layer 16 to the thickness of the substantially intrinsic semiconductor layer is greater than two. For certain configurations, the substantially intrinsic semiconductor layer 16 comprises a plurality of grains, and at least ninety percent (90%) of the grains (in cross-sectional view) are characterized by a grain size of at least about five (5) µm.

As shown, for example in FIGS. 5 and 9, the monolithically integrated PV module 200 further includes a second electrically conductive layer 22. For both configurations, the substantially intrinsic semiconductor layer 16 is disposed between the p-type semiconductor layer 14 and the n-type semiconductor layer 18, thereby forming the active semiconductor stack 30 (as shown in FIGS. 3 and 8). For the n-i-p arrangement shown in FIG. 5, the n-type semiconductor layer 18 is disposed between the intrinsic semiconductor layer 16 and the second electrically conductive layer 22. Similarly, for the p-i-n arrangement shown in FIG. 9, the p-type semiconductor layer 14 is disposed between the intrinsic semiconductor layer 16 and the second electrically conductive layer 22. The n-type semiconductor layer 18 and the second electrically conductive layer 22 are discussed above with reference to FIGS. 3 and 8 in detail.

For the example configuration shown in FIGS. 4 and 9, at least one first trench 11 extends through the back contact metal layer 28. Each of the first trenches 11 separates the back contact metal layer 28 for a respective PV cell 210 (see, for example FIGS. 3 and 8) from the back contact metal layer 28 of a respective neighboring PV cell 210. For particular embodiments the width W₁ (see FIGS. 5 and 11) of the first trenches 11 is in a range of about 50-200 µm. For certain configurations, the width W₁ is selected to be at least two times the thickness of the absorber layer 14.

As shown, for example in FIGS. 5 and 9, at least one second trench 13 extends through the p-type semiconductor, substantially intrinsic semiconductor, and n-type semiconductor layers 14, 16, 18. Each of the second trenches 13 separates the p-type semiconductor, substantially intrinsic semiconductor, and n-type semiconductor layers (collectively, the active semiconductor stack 30) 14, 16, 18 for a respective PV cell 210 (see, for example FIGS. 3 and 8) from the active PV semiconductor stack 30 of a respective neighboring PV cell 210. For particular embodiments, the width W₂ (see FIGS. 5 and 9) of the second trenches 13 is in a range of about 50-200 µm. The width W₂ for the second trenches 13 may be selected to balance the increased area loss with the lower resistances associated with greater widths W₂.

At least one third trench 15 extends through the second electrically conductive layer 22, such that each of the third trenches 15 separates the second electrically conductive layer 22 for a respective CdTe PV cell 210 (see, for example FIGS. 3 and 8) from the second electrically conductive layer 22 of a respective neighboring CdTe PV cell 210. For the example arrangements shown in FIGS. 5 and 11, at least one third trench 15 extends through each of the active PV semiconductor and second electrically conductive layers 14, 16, 18, 22. Each of the third trenches 15 separates the active PV semiconductor and second electrically conductive layers 14, 16, 18, 22 for a respective CdTe PV cell 210 (see, for example FIGS. 3 and 8) from the active PV semiconductor and second electrically conductive layers 14, 16, 18, 22 of a respective neighboring CdTe PV cell 210. For certain configurations the width W₃ is selected to be at least two times the thickness of the p-type semiconductor layer 14.

For ease of illustration, only a single set of first, second and third trenches 11, 13, 15 is shown in FIGS. 4, 5, 7, and 9. However, PV module 200 may include a number of these trenches, such that a number of PV cells 210 are included in the module 200.

For the example configuration shown in FIGS. 4 and 5, each of the first trenches 11 is at least partially filled with the material forming the p-type semiconductor layer 14, such that the first trenches 11 and the p-type semiconductor layer 14 form an integral piece. Similarly, the example configuration shown in FIG. 9, each of the first trenches 11 is at least partially filled with the material forming the n-type semiconductor layer 18, such that the first trenches 11 and the n-type semiconductor layer 18 form an integral piece.

For the example configurations shown in FIGS. 5 and 9, each of the second trenches 13 is at least partially filled with the material forming the second electrically conductive layer 22, such that the second trenches 13 and the second electrically conductive layer 22 form an integral piece. More generally, the second trenches 13 are at least partially filled with electrically conductive interconnecting material having a resistivity of less than about 10⁻³ Ohm-cm to provide an electrical current pathway from the second electrically conductive layer 22 of a PV cell 210 to the back contact metal layer 28 of a neighboring PV cell 210, as indicated for example in FIGS. 5 and 9. The electrically conductive interconnecting material is patterned in such a way that it does not electrically connect the second electrically conductive layers 22 of PV cell 10. Suitable conductive polymers that may be used to provide the electrically conductive interconnecting material may include, without limitation, polyaniline, polyacetylene, poly-3,4-ethylene dioxy thiophene (PEDOT), poly-3,4-propylene dioxythiophene (PProDOT), polystyrene sulfonate (PSS), polyvinyl carbazole (PVK), organometallic precursors, dispersions or carbon nanotubes, etc.

Although not expressly shown, the first trenches 11 may be at least partially filled with an electrically resistive material. The electrically resistive material may have a resistivity greater than about 10 Ohm-cm, according to one aspect of the invention. Suitable example materials include, without limitation, negative photo-resist. For particular embodiments, one or more of the first, second and third trenches 11, 13, 15 are at least partially filled by a liquid dispense method such as, without limitation, inkjet printing, screen printing, flexo printing, gravure printing, aerosol dispense, extrusion, syringe dispense, or any combination thereof.

Similarly, the third trenches 15 may be at least partially filled with an electrically resistive material (not expressly shown). The electrically resistive material may have a resistivity greater than about 10 ohm-cm, according to one aspect of the invention. Suitable example materials include, without limitation, SiO₂-like or Al₂O₃-like materials, which can be printed within the scribe.

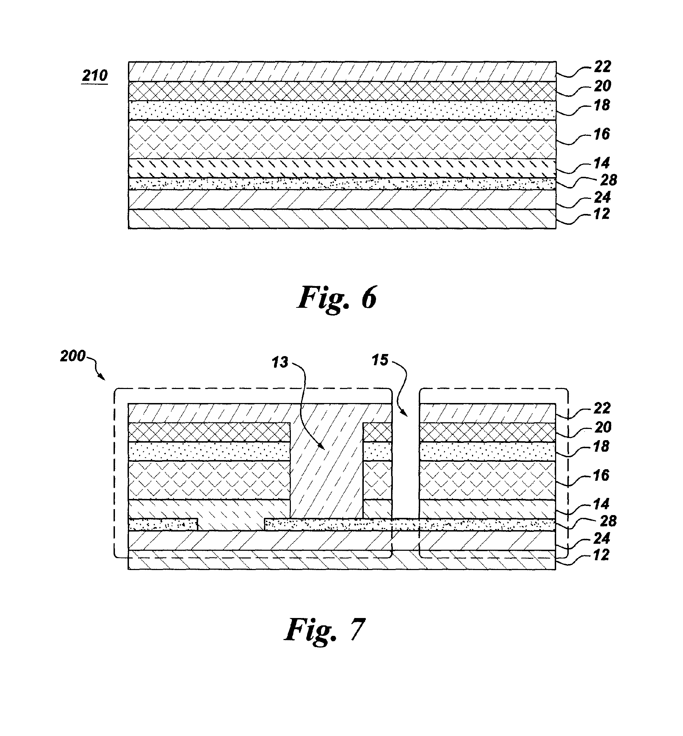

FIGS. 6 and 7 illustrate additional optional features of monolithically integrated PV module 100. FIG. 6 is a schematic cross-sectional diagram of an example PV stack 210 with an HRT layer 20 and manufactured in a "substrate" geometry, and FIG. 7 is a schematic cross-sectional diagram of an example monolithically integrated PV module 200 deposited in a "substrate" geometry and including the HRT layer 20 of FIG. 6. For the example configuration shown in FIG. 7, the monolithically integrated PV module 200 further includes a high resistance transparent conductive oxide (HRT) layer 20 disposed between the n-type semiconductor layer 18 and the second electrically conductive layer 22. As indicated in FIG. 7, the second and third trenches 13, 15 also extend through the HRT layer 20. According to a particular embodiment, the thickness of the HRT layer 20 is in a range of about 50 nm to about 100 nm. Beneficially, the HRT layer 20 serves as a buffer layer and can increase the efficiency of the PV cell 210. Non-limiting examples of suitable materials for HRT layer 20 include tin dioxide (SnO₂) ZTO (zinc stannate), zinc-doped tin oxide (SnO₂:Zn), zinc oxide (ZnO), indium oxide (In₂O₃), and combinations thereof. For the p-i-n configuration shown in FIGS. 8 and 9, the HRT layer will not be present because a p-type window layer is used, with the n-type layer disposed in the bottom of the device.

A method for monolithically integrating photovoltaic (PV) cells (210) deposited in a "substrate" geometry is described with reference to FIGS. 4-9. As indicated, for example in FIG. 4, the monolithic integration method includes providing a first electrically conductive layer 12. As discussed above, example materials for the first electrically conductive layer 12 include nickel, copper, molybdenum, stainless steel and alloys thereof. These materials may be deposited, for example by sputtering or evaporation. In addition, these materials may also be provided as a foil, such that flexible devices can be created. The metal foil may be up to a few mm in thickness. For particular embodiments, the first electrically conductive layer 12 comprises a textured substrate 12, which may be formed using known metal deformation techniques, such as but not limited to rolling deformation and annealing processes. As noted above, for certain configurations, the first electrically conductive layer 12 comprises a textured substrate 12 with a thin metal film (not shown) deposited thereon. The thin film may be deposited by sputtering or evaporation or may be provided as a foil.

For the example process shown in FIG. 4, the monolithic integration method further includes depositing an insulating layer 24 above the first electrically conductive layer 12. For the illustrated examples, the insulating layer 24 is deposited on the first electrically conductive layer 12. However, there may be intermediate layers as well. Where a textured substrate 12 is used, the deposition of the insulating layer 24 is performed such that the insulating layer 24 is conformal with the roughness of the textured substrate 12. For particular arrangements, the insulating layer 24 may be deposited using a vapor phase deposition technique. Other example deposition techniques are described in U.S. Patent Application, Ser. No. 12/138,001, "Insulating coating, methods of manufacture thereof and articles comprising the same," which is incorporated herein in its entirety.

According to a particular embodiment, the insulating layer 24 is deposited in an expanding thermal plasma (ETP), and a metal organic precursor is used in the plasma. More particularly, the precursor is introduced into an ETP and a plasma stream produced by the ETP is disposed upon the surface of the first electrically conductive layer 12 (or an intermediate layer, not shown). For more particular embodiments, the metal-organic precursor comprises silicon, titanium, tin, lead, or germanium. Prior to applying the insulating layer 24, the first electrically conductive layer 12 can be etched if desired. For a particular process, the first electrically conductive layer 12 is first heated to the desired temperature following which the insulating layer is disposed thereon.

As explained in U.S. Patent Application, Ser. No. 12/138,001, the use of ETP permits the rapid deposition of the insulating layer at relatively low temperatures, as compared to other techniques, such as sputtering or plasma enhanced chemical vapor deposition (PECVD). Under certain processing parameters, the insulating layer 24 can be deposited at a rate greater than or equal to about 0.1 µm per minute, and more particularly, at a rate greater than or equal to about 5 µm per minute, and still more particularly, at a rate greater than or equal to about 10 µm per minute, and even more particularly, at a rate greater than or equal to about 100 µm per minute. For particular arrangements, the insulating layer 24 is deposited at a rate of about 0.1 -100 µm per minute and has a thickness of about 1-50 µm.

Similar to the discussion in U.S. Patent Application, Ser. No. 12/138,001, ETP can be used to apply the insulating layer to large areas of the first electrically conductive layer 12 in a single operation. The insulating layer may comprise a single layer that is applied in a single step or in multiple steps if desired. Multiple sets of plasma generators may be used to increase deposition rate and/or the area of coverage. The ETP process may be carried out in a single deposition chamber or in multiple deposition chambers.

For the example process shown in FIG. 4, the monolithic integration method further includes depositing a back contact metal layer 28 above the insulating layer 24. Although for the illustrated examples, the metal back contact layer 28 is deposited on the insulating layer 24, there may also be one or more intermediate layers (not shown). The metal back contact layer 28 is typically deposited using sputtering or evaporation (for example, e-beam or molecular beam epitaxy).

The example monolithic integration process shown in FIG. 4 further includes forming at least one first trench 11 extending through the back contact metal layer 28. The first trenches 11 are discussed above and may be formed, for example, by performing a laser or mechanical scribe. For the example process shown in FIG. 4, the monolithic integration method further includes depositing an active semiconductor stack 30 above the back contact metal layer 28. As shown for example in FIGS. 3 and 10, the active semiconductor stack 30 comprises a substantially intrinsic semiconductor layer 16 disposed between a p-type semiconductor layer 14 and an n-type semiconductor layer 14.

For the example process shown in FIG. 4, the p-type semiconductor layer 14 is deposited at least partially above the back contact metal layer 28, the substantially intrinsic semiconductor layer 16 is deposited above the p-type semiconductor layer 14, and the n-type semiconductor layer 18 is deposited above the substantially intrinsic semiconductor layer 16, thereby forming an n-i-p structure 30. Similarly, for the p-i-n configuration shown in FIGS. 8 and 9, the n-type semiconductor layer 18 is deposited at least partially above the back contact metal layer, the substantially intrinsic semiconductor layer 16 is deposited above the n-type semiconductor layer 18, and the p-type semiconductor layer 14 is deposited above the substantially intrinsic semiconductor layer 16. Example materials for the semiconductor layers 14, 16 and 18 are listed above. The p-type and intrinsic layers 16 are typically deposited by close space sublimation (CSS) or vapor phase transport. Alternatively, the p-type and/or intrinsic layers 14, 16 may be deposited using sputtering, evaporation (for example, e-beam or molecular beam epitaxy), or chemical vapor deposition.

Example materials for the n-type semiconductor layer 18 are listed above. The n-type layer 18 is typically deposited by chemical bath (or vapor) deposition or electrochemical deposition. For example, chemical bath deposition may be used to deposit a CdS layer 18. Alternatively, the n-type layer 18 may also be deposited using sputtering. Dopants may be introduced within semiconductor layers 14 and/or 18 using a variety of techniques, as discussed, for example, in commonly assigned US. Patent Application Ser. No. 12/415,267, "Layer for Thin Film Photovoltaics and a Solar Cell Made Therefrom," which is incorporated by reference herein in its entirety.

As shown for example in FIG. 5, the monolithic integration method further includes forming at least one second trench 13 extending through the p-type, substantially intrinsic and n-type semiconductor layers 14, 16, 18. The second trenches 13 are discussed above and may be formed, for example, by performing a laser or mechanical scribe.

The example monolithic integration process shown in FIG. 5 further includes depositing a second electrically conductive layer 22 at least partially above the active semiconductor stack 30. For the n-i-p configuration of FIG. 5, the second electrically conductive layer 22 is deposited above the n-type layer 18, whereas for the p-i-n configuration of FIG. 9, the second electrically conductive layer 22 is deposited above the p-type layer 14. The second electrically conductive layer (or back contact) 22 is typically deposited by sputtering a TCO layer 22.

The monolithic integration method further includes forming at least one third trench 15 extending through the second electrically conductive layer 22. For the example arrangement shown for in FIGS. 5 and 9, the monolithic integration method further includes forming at least one third trench 15 extending through each of the p-type semiconductor, substantially intrinsic semiconductor, n-type semiconductor and second electrically conductive layers 14, 16, 18, 22. The third trenches 15 are discussed above and may be formed, for example, by performing a laser or mechanical scribe.

For the example process shown in FIGS. 4 and 5, the first trenches 11 are formed prior to the deposition of the p-type semiconductor layer 14. For this particular process sequence, the step of depositing the p-type semiconductor layer 14 further comprises at least partially filling the first trenches 11 with the material forming the p-type semiconductor layer 14, such that the first trenches 11 and the p-type semiconductor layer 14 form an integral piece.

Similarly, for the example p-i-n device configuration shown in FIG. 9, the first trenches 11 are formed prior to the deposition of the n-type semiconductor layer 18. For this particular process sequence, the step of depositing the n-type semiconductor layer 18 further comprises at least partially filling the first trenches 11 with the material forming the n-type semiconductor layer 18, such that the first trenches 11 and the n-type semiconductor layer 18 form an integral piece, as shown in FIG. 9.

Similarly, for the example process shown in FIG. 5, the second trenches 13 are formed prior to the deposition of the second electrically conductive layer 22. For this particular process sequence, the step of depositing the second electrically conductive layer 22 further comprises at least partially filling the second trenches 13 with the material forming the second electrically conductive layer 22, such that the second trenches 13 and the second electrically conductive layer 22 form an integral piece, as indicated in FIG. 5.

For another process sequence (not expressly shown), the first, second and third trenches 11, 13, 15 are formed after the deposition of the second electrically conductive layer 22. For this process sequence, the three scribes may be performed in a single step, after the deposition of the various layers forming the PV device. For this particular process sequence, the monolithic integration method further includes at least partially filling the first trenches 11 with an electrically resistive material and at least partially filling the second trenches 13 with an electrically conductive material. For this embodiment, the scribes may be performed sequentially or simultaneously. Beneficially, performing the scribes simultaneously improves their alignment. The electrically conductive material may have a resistivity of less than about 10⁻³ Ohm-cm to provide an electrical current pathway from the second electrically conductive layer 22 of a PV cell 10 to the back contact metal layer 28 of a neighboring PV cell 10. Example conductive polymers that may be used to provide the electrically conductive interconnecting material are listed above.

For another process sequence (not expressly shown), the monolithic integration method further includes at least partially filling the third trenches 15 with an electrically resistive material. Example electrically resistive materials are listed above.

Similarly, for another process sequence (not expressly shown), the first and second trenches 11, 13 are formed simultaneously prior to deposition of the second electrically conductive layer 22. For this particular process sequence, the monolithic integration method further includes at least partially filling the first trenches 11 with an electrically resistive material. Example electrically resistive materials are listed above.

For the example arrangement illustrated in FIGS 6 and 7, the monolithic integration method further includes depositing a high resistance transparent conductive oxide (HRT) layer 20 after depositing the n-type semiconductor layer 18 and before depositing the second electrically conductive layer 22. For the illustrated arrangement, the second and third trenches 13, 15 are formed after the deposition of the HRT layer 20, such that the second and third trenches 13, 15 also extend through the HRT layer, as shown for example in FIG. 7. The optional HRT layer 20 is typically deposited using sputtering.

Beneficially, the above-described methodologies facilitate the monolithic integration of CdTe PV cells with n-i-p or p-i-n configurations into solar modules on metallic substrates. In addition, the present invention improves upon prior art PV devices by having large grains with enhanced carrier lifetime, while going to a p-i-n type of device with a reduction in lifetime diminishing grain-boundaries. Consequently, higher V_{oc} values can be achieved.

Although only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. A monolithically integrated photovoltaic (PV) module comprising:
   a first electrically conductive layer;
   an insulating layer, wherein the first electrically conductive layer is disposed below the insulating layer;
   a back contact metal layer;
   a p-type semiconductor layer;
   a substantially intrinsic semiconductor layer with a median grain size of at least about five (5) µm and comprising cadmium and tellurium;
   an n-type semiconductor layer, wherein the substantially intrinsic semiconductor layer is disposed between the p-type semiconductor layer and the n-type semiconductor layer forming an active semiconductor stack, wherein the back contact metal layer is disposed between the insulating layer and the active semiconductor stack;
   a second electrically conductive layer, wherein the second electrically conductive layer is disposed above the active semiconductor stack;
   at least one first trench extending through the back contact metal layer, wherein each of the at least one first trenches separates the back contact metal layer for a respective PV cell from the back contact metal layer of a respective neighboring PV cell;
   at least one second trench extending through the p-type semiconductor, substantially intrinsic semiconductor, and n-type semiconductor layers, wherein each of the at least one second trenches separates the p-type semiconductor, substantially intrinsic semiconductor, and n-type semiconductor layers for a respective PV cell from the p-type semiconductor, substantially intrinsic semiconductor, and n-type semiconductor layers of a respective neighboring PV cell; and
   at least one third trench extending through the second electrically conductive layer, wherein each of the at least one third trenches separates the second electrically conductive layer for a respective PV cell from the second electrically conductive layer of a respective neighboring PV cell.
2. The monolithically integrated PV module of clause 1, wherein the substantially intrinsic semiconductor layer has a thickness of less than two (2) µm.
3. The monolithically integrated PV module of any preceding clause, wherein the ratio of the median grain size for the substantially intrinsic semiconductor layer to the thickness of the substantially intrinsic semiconductor layer is greater than two.
4. The monolithically integrated PV module of any preceding clause, wherein the substantially intrinsic semiconductor layer comprises a plurality of grains, and wherein at least ninety percent (90%) of the grains are characterized by a grain size of at least about five (5) µm.
5. The monolithically integrated PV module of any preceding clause, wherein the first electrically conductive layer comprises a textured substrate.
6. The monolithically integrated PV module of any preceding clause, wherein the insulating layer is conformal with the roughness of the textured substrate.
7. The monolithically integrated PV module of any preceding clause, wherein the back contact metal layer is disposed between the insulating layer and the p-type semiconductor absorber layer, and wherein the n-type semiconductor layer is disposed between the substantially intrinsic semiconductor layer and the second electrically conductive layer.
8. The monolithically integrated PV module of any preceding clause, wherein the at least one first trench is at least partially filled with the material forming the p-type semiconductor layer, such that the at least one first trench and the p-type semiconductor layer form an integral piece.
9. The monolithically integrated PV module of any preceding clause, further comprising a high resistance transparent conductive oxide (HRT) layer disposed between the n-type semiconductor layer and the second electrically conductive layer, wherein the second and third trenches extend through the HRT layer.
10. The monolithically integrated PV module of any preceding clause, wherein the back contact metal layer is disposed between the insulating layer and the n-type semiconductor absorber layer, and wherein the p-type semiconductor layer is disposed between the substantially intrinsic semiconductor layer and the second electrically conductive layer.
11. The monolithically integrated PV module of any preceding clause, wherein the at least one first trench is at least partially filled with the material forming the n-type semiconductor layer, such that the at least one first trench and the n-type semiconductor layer form an integral piece.
12. The monolithically integrated PV module of any preceding clause, wherein the at least one second trench is at least partially filled with the material forming the second electrically conductive layer, such that the at least one second trench and the second electrically conductive layer form an integral piece.
13. The monolithically integrated PV module of any preceding clause, wherein the at least one first trench is at least partially filled with an electrically resistive material.
14. The monolithically integrated PV module of any preceding clause, wherein the at least one third trench is at least partially filled with an electrically resistive material.
15. The monolithically integrated PV module of any preceding clause, wherein the n-type semiconductor layer comprises CdS.
16. The monolithically integrated PV module of any preceding clause, wherein the insulating layer comprises silicon, titanium, tin, lead, or germanium.
17. The monolithically integrated PV module of any preceding clause, wherein the insulating layer has the formula SiOₓC_{y}H_{z}, and wherein x, y and z each have values in a range of about 0.001-2 respectively.
18. The monolithically integrated PV module of any preceding clause, wherein the at least one third trench also extends through each of the p-type semiconductor, substantially intrinsic semiconductor, and n-type semiconductor layers, and wherein each of the at least one third trenches separates the p-type semiconductor, substantially intrinsic semiconductor, n-type semiconductor and second electrically conductive layers for a respective PV cell from the p-type semiconductor, substantially intrinsic semiconductor, n-type semiconductor and second electrically conductive layers of a respective neighboring PV cell.
19. A method for monolithically integrating photovoltaic (PV) cells comprising:
   providing a first electrically conductive layer;
   depositing an insulating layer above the first electrically conductive layer;
   depositing a back contact metal layer above the insulating layer;
   forming at least one first trench extending through the back contact metal layer, wherein each of the at least one first trenches separates the back contact metal layer for a respective PV cell from the back contact metal layer of a respective neighboring PV cell;
   depositing an active semiconductor stack above the back contact metal layer, wherein the active semiconductor stack comprises a substantially intrinsic semiconductor layer with a median grain size of at least about five (5) µm disposed between a p-type semiconductor layer and an n-type semiconductor layer;
   forming at least one second trench extending through the p-type, substantially intrinsic and n-type semiconductor layers, wherein each of the at least one second trenches separates the p-type, substantially intrinsic and n-type semiconductor layers for a respective PV cell from the p-type, substantially intrinsic and n-type semiconductor layers of a respective neighboring PV cell;
   depositing a second electrically conductive layer at least partially above the active semiconductor stack; and
   forming at least one third trench extending through the second electrically conductive layer, wherein each of the at least one third trenches separates the second electrically conductive layer for a respective PV cell from the second electrically conductive layers of a respective neighboring PV cell.
20. The monolithic integration method of any preceding clause, wherein the first electrically conductive layer comprises a textured substrate.
21. The monolithic integration method of any preceding clause, wherein the step of depositing the insulating layer is performed such that the insulating layer is conformal with the roughness of the textured substrate.
22. The monolithic integration method of any preceding clause, wherein the step of depositing the active semiconductor stack comprises:
   depositing the p-type semiconductor layer at least partially above the back contact metal layer;
   depositing the substantially intrinsic semiconductor layer above the p-type semiconductor layer; and
   depositing the n-type semiconductor layer above the substantially intrinsic semiconductor layer.
23. The monolithic integration method of any preceding clause, wherein the step of forming at least one first trench is performed prior to the step of depositing the p-type semiconductor layer, and wherein the step of depositing the p-type semiconductor layer further comprises at least partially filling the at least one first trench with the material forming the p-type semiconductor layer, such that the at least one first trench and the p-type semiconductor layer form an integral piece.
24. The monolithic integration method of any preceding clause, further comprising depositing a high resistance transparent conductive oxide (HRT) layer after depositing the n-type semiconductor layer and before depositing the second electrically conductive layer, wherein the steps of forming the second and third trenches are performed after the deposition of the HRT layer, such that the second and third trenches extend through the HRT layer.
25. The monolithic integration method of any preceding clause, wherein the step of depositing the active semiconductor stack comprises:
   depositing the n-type semiconductor layer at least partially above the back contact metal layer;
   depositing the substantially intrinsic semiconductor layer above the n-type semiconductor layer; and
   depositing the p-type semiconductor layer above the substantially intrinsic semiconductor layer.
26. The monolithic integration method of any preceding clause, wherein the step of forming at least one first trench is performed prior to the step of depositing the n-type semiconductor layer, and wherein the step of depositing the n-type semiconductor layer further comprises at least partially filling the at least one first trench with the material forming the n-type semiconductor layer, such that the at least one first trench and the n-type semiconductor layer form an integral piece.
27. The monolithic integration method of any preceding clause, wherein the step of forming at least one second trench is performed prior to the step of depositing the second electrically conductive layer, and wherein the step of depositing the second electrically conductive layer further comprises at least partially filling the at least one second trench with the material forming the second electrically conductive layer, such that the at least one second trench and the second electrically conductive layer form an integral piece.
28. The monolithic integration method of any preceding clause, wherein the steps of forming the first, second and third trenches are performed after the step of depositing the second electrically conductive layer, the monolithic integration method further comprising:
   at least partially filling the at least one first trench with an electrically resistive material; and
   at least partially filling the at least one second trench with an electrically conductive material.
29. The monolithic integration method of any preceding clause, further comprising at least partially filling the at least one third trench with an electrically resistive material.
30. The monolithic integration method of any preceding clause, wherein the at least one third trench also extends through each of the p-type semiconductor, substantially intrinsic semiconductor, and n-type semiconductor layers, and wherein each of the at least one third trenches separates the p-type semiconductor, substantially intrinsic semiconductor, n-type semiconductor and second electrically conductive layers for a respective PV cell from the p-type semiconductor, substantially intrinsic semiconductor, n-type semiconductor and second electrically conductive layers of a respective neighboring PV cell.
31. The monolithic integration method of any preceding clause, wherein the first, second and third trenches are formed after the deposition of the second electrically conductive layer.

## Claims

1. A monolithically integrated photovoltaic (PV) module (200) comprising:
a first electrically conductive layer (12);
an insulating layer (24), wherein the first electrically conductive layer is disposed below the insulating layer;
a back contact metal layer (28);
a p-type semiconductor layer (14);
a substantially intrinsic semiconductor layer (16) with a median grain size of at least about five (5) µm and comprising cadmium and tellurium;
an n-type semiconductor layer (18), wherein the substantially intrinsic semiconductor layer (16) is disposed between the p-type semiconductor layer (14) and the n-type semiconductor layer (18) forming an active semiconductor stack (30), wherein the back contact metal layer is disposed between the insulating layer and the active semiconductor stack (30);
a second electrically conductive layer (22), wherein the second electrically conductive layer (22) is disposed above the active semiconductor stack (30);
at least one first trench (11) extending through the back contact metal layer (28), wherein each of the at least one first trenches (11) separates the back contact metal layer (28) for a respective PV cell (210) from the back contact metal layer (28) of a respective neighboring PV cell (210);
at least one second trench (13) extending through the p-type semiconductor, substantially intrinsic semiconductor, and n-type semiconductor layers (14, 16, 18), wherein each of the at least one second trenches (13) separates the p-type semiconductor, substantially intrinsic semiconductor, and n-type semiconductor layers (14, 16, 18) for a respective PV cell (210) from the p-type semiconductor, substantially intrinsic semiconductor, and n-type semiconductor layers (14, 16, 18) of a respective neighboring PV cell (210); and
at least one third trench (15) extending through the second electrically conductive layer (22), wherein each of the at least one third trenches (15) separates the second electrically conductive layer (22) for a respective PV cell (210) from the second electrically conductive layer (22) of a respective neighboring PV cell (210).

2. The monolithically integrated PV module (200) of claim 1, wherein the first electrically conductive layer (12) comprises a textured substrate (12), wherein the insulating layer (24) is conformal with the roughness of the textured substrate (12).

3. The monolithically integrated PV module (200) of any preceding claim, wherein the back contact metal layer (28) is disposed between the insulating layer (24) and the p-type semiconductor absorber layer (14), wherein the n-type semiconductor layer (18) is disposed between the substantially intrinsic semiconductor layer (16) and the second electrically conductive layer (22), and wherein the at least one first trench (11) is at least partially filled with the material forming the p-type semiconductor layer (14), such that the at least one first trench (11) and the p-type semiconductor layer (14) form an integral piece.

4. The monolithically integrated PV module (200) of any preceding claim, wherein the back contact metal layer (28) is disposed between the insulating layer (24) and the p-type semiconductor absorber layer (14), and wherein the n-type semiconductor layer (18) is disposed between the substantially intrinsic semiconductor layer (16) and the second electrically conductive layer (22), the monolithically integrated PV module further comprising a high resistance transparent conductive oxide (HRT) layer (20) disposed between the n-type semiconductor layer (18) and the second electrically conductive layer (22), wherein the second and third trenches (13, 15) extend through the HRT layer.

5. The monolithically integrated PV module (200) of any preceding claim, wherein the back contact metal layer (28) is disposed between the insulating layer (24) and the n-type semiconductor absorber layer (18), wherein the p-type semiconductor layer (14) is disposed between the substantially intrinsic semiconductor layer (16) and the second electrically conductive layer (22), and wherein the at least one first trench (11) is at least partially filled with the material forming the n-type semiconductor layer (18), such that the at least one first trench (11) and the n-type semiconductor layer (18) form an integral piece.

6. The monolithically integrated PV module (200) of any preceding claim, wherein the at least one second trench (13) is at least partially filled with the material forming the second electrically conductive layer (22), such that the at least one second trench (13) and the second electrically conductive layer (22) form an integral piece.

7. The monolithically integrated PV module (200) of any preceding claim, wherein the at least one third trench (15) also extends through each of the p-type semiconductor, substantially intrinsic semiconductor, and n-type semiconductor layers (14, 16, 18), and wherein each of the at least one third trenches (15) separates the p-type semiconductor, substantially intrinsic semiconductor, n-type semiconductor and second electrically conductive layers (14, 16, 18, 22) for a respective PV cell (210) from the p-type semiconductor, substantially intrinsic semiconductor, n-type semiconductor and second electrically conductive layers (14, 16, 18, 22) of a respective neighboring PV cell (210).

8. A method for monolithically integrating photovoltaic (PV) cells (210) comprising:
providing a first electrically conductive layer (12);
depositing an insulating layer (24) above the first electrically conductive layer (12);
depositing a back contact metal layer (28) above the insulating layer (24);
forming at least one first trench (11) extending through the back contact metal layer (28), wherein each of the at least one first trenches (11) separates the back contact metal layer (28) for a respective PV cell (210) from the back contact metal layer (28) of a respective neighboring PV cell (210);
depositing an active semiconductor stack (30) above the back contact metal layer (28), wherein the active semiconductor stack (30) comprises a substantially intrinsic semiconductor layer (16) with a median grain size of at least about five (5) µm disposed between a p-type semiconductor layer (14) and an n-type semiconductor layer (14);
forming at least one second trench (13) extending through the p-type, substantially intrinsic and n-type semiconductor layers (14, 16, 18), wherein each of the at least one second trenches (13) separates the p-type, substantially intrinsic and n-type semiconductor layers (14, 16, 18) for a respective PV cell (210) from the p-type, substantially intrinsic and n-type semiconductor layers (14, 16, 18) of a respective neighboring PV cell (210);
depositing a second electrically conductive layer (22) at least partially above the active semiconductor stack (30); and
forming at least one third trench (15) extending through the second electrically conductive layer (22), wherein each of the at least one third trenches (15) separates the second electrically conductive layer (22) for a respective PV cell (210) from the second electrically conductive layers (22) of a respective neighboring PV cell (210).

9. The monolithic integration method of Claim 8, wherein the step of depositing the active semiconductor stack (30) comprises:
depositing the p-type semiconductor layer (14) at least partially above the back contact metal layer;
depositing the substantially intrinsic semiconductor layer (16) above the p-type semiconductor layer (14); and
depositing the n-type semiconductor layer (18) above the substantially intrinsic semiconductor layer (16),
wherein the step of forming at least one first trench (11) is performed prior to the step of depositing the p-type semiconductor layer (14), and wherein the step of depositing the p-type semiconductor layer (14) further comprises at least partially filling the at least one first trench (11) with the material forming the p-type semiconductor layer (14), such that the at least one first trench (11) and the p-type semiconductor layer (14) form an integral piece.

10. The monolithic integration method of claim 8 or claim 9, wherein the step of depositing the active semiconductor stack (30) comprises:
depositing the n-type semiconductor layer (18) at least partially above the back contact metal layer;
depositing the substantially intrinsic semiconductor layer (16) above the n-type semiconductor layer (18); and
depositing the p-type semiconductor layer (14) above the substantially intrinsic semiconductor layer (16),
wherein the step of forming at least one first trench (11) is performed prior to the step of depositing the n-type semiconductor layer (18), and wherein the step of depositing the n-type semiconductor layer (18) further comprises at least partially filling the at least one first trench (11) with the material forming the n-type semiconductor layer (18), such that the at least one first trench (11) and the n-type semiconductor layer (18) form an integral piece.
